# EUROPÄISCHE PATENTSCHRIFT

(11) **EP 1 315 853 B1**
(45) Veröffentlichungstag und Bekanntmachung des Hinweises auf die Patenterteilung: **15.09.2004**
(21) Anmeldenummer: 01965120.7
(22) Anmeldetag: 12.07.2001
(51) Int. Cl.: C30B 25/00, C23C 16/44, B01J 4/00, B25J 21/02

(54) **VORRICHTUNG ZUM ABSCHEIDEN INSBESONDERE KRISTALLINER SCHICHTEN AUF INSBESONDERE KRISTALLINEN SUBSTRATEN**
DEVICE FOR THE DEPOSITION OF, IN PARTICULAR, CRYSTALLINE LAYERS ON, IN PARTICULAR, CRYSTALLINE SUBSTRATES
DISPOSITIF DE DEPOSITION, NOTAMMENT DE COUCHES CRISTALLINES SUR, NOTAMMENT, DES SUBSTRATS CRISTALLINS

(30) Priorität: 01.09.2000 DE 10043597
(43) Veröffentlichungstag der Anmeldung: 04.06.2003
(73) Patentinhaber: Aixtron AG, 52072 Aachen (DE)
(72) Erfinder: JÜRGENSEN, Holger, 52072 Aachen (DE); STRAUCH, Gerd, 52072 Aachen (DE); KÄPPELER, Johannes, 52146 Würselen (DE)
(74) Vertreter: Grundmann, Dirk, Dr.
(86) Internationale Anmeldenummer: PCT/EP2001/008038
(87) Internationale Veröffentlichungsnummer: WO 2002/018679

(56) Entgegenhaltungen:
- EP-A- 0 524 073
- WO-A-96/00314
- DE-A- 19 813 523

## Beschreibung

Die Erfindung betrifft eine Vorrichtung zum Abscheiden, insbesondere kristalliner Schichten auf einem oder mehreren, insbesondere ebenfalls kristallinen Substraten, mit einer in einem Reaktorgehäuse angeordneten Prozesskammer, welche von oben durch eine mittels eines Deckels verschließbare Reaktoröffnung mit den Substraten beladbar ist, wobei die Reaktorgehäuseöffnung in eine, insbesondere reinstgasgespülte Handschuhbox mündet und zum Deckel Strom-, Flüssigkeits- oder Gasverbindungsleitungen führen.

Derartige Vorrichtungen sind im Gebrauch, wobei mit diesen CVD-Anlagen Halbleiterschichten auf Halbleitersubstraten abgeschieden werden. Als Reaktionsgase finden unter anderem metallorganische Verbindungen und Hydride Verwendung, beispielsweise von Elementen der III. und V. Hauptgruppe.

Ein Reaktorgehäuse, welches eine deckelverschlossene Reaktorgehäuseöffnung besitzt, wobei zum Deckel Gaszuleitungen führen zeigt die US 5,027,464. Auch das DE-Patent 19 813 523 C2 zeigt ein derartiges Reaktorgehäuse mit darin befindlicher Prozesskammer.

Die US 5,788,777 zeigt eine Vorrichtung zum Abscheiden von SiC. Dort werden die Reaktionsgase, Silan und Propan zusammen mit einem Trägergas, Wasserstoff durch ein zentrales Gaseinlassorgan bis zur Prozesskammer geleitet. Das zentrale Gaseinlassorgan trägt eine Deckplatte der Prozesskammer.

Der Erfindung liegt die Aufgabe zugrunde, die Führung von Verbindungsleitungen von außerhalb einer Handschuhbox angeordneten Strom-, Flüssigkeits- oder Gasquellen zum innerhalb der Handschuhbox angeordneten Deckel des Reaktorgehäuses zu verbessern.

Gelöst wird die Aufgabe durch die in den Ansprüchen angegebene Erfindung. Der Anspruch 1 sieht vor, dass die Strom-, Flüssigkeits- oder Gasverbindungsleitungen frei durch einen flexiblen, einendseitig dicht mit einem starr am Deckel sitzenden Anflanschorgan und anderendseitig dicht mit einer Öffnung der Handschuhboxwandung verbundenen Schlauch geführt sind. In einer Weiterbildung der Erfindung sitzt das Anflanschorgan nicht unmittelbar am Deckel, sondern ist vom Deckel beabstandet. Hierzu ist ein Träger vorgesehen, der das Anflanschorgan starr am Deckel hält. Das Anflanschorgan kann eine Kunststoffplatte sein. Dies erleichtert die Durchführung von elektrischen Leitern, wie insbesondere den Zuleitungen für die HF-Spule. In einer bevorzugten Ausgestaltung der Erfindung sitzt die Deckplatte der Prozesskammer fest am Deckel. Zwischen dem Reaktorgehäusedeckel und der Deckplatte liegt die ebenfalls fest mit dem Deckel verbundene HF-Spule. Wird der Dekkel zum Beladen oder Entladen der Prozesskammer mit Substraten angehoben, was mit geeigneten Pneumatikzylinder erfolgen kann, so heben sich HF-Spule und Prozesskammerdeckplatte mit an. Dabei wird der flexible Schlauch gestaucht. Die darin frei geführten Versorgungsleitungen verschieben sich dann durch die Öffnung der Handschuhbox. Als Schlauch eignet sich besonders ein Wellschlauch.

Die Beheizung der Trägerplatte erfolgt von unten ebenfalls mit einer HF-Spule. Die beiden HF-Spulen können von getrennten HF-Generatoren gespeist werden. Hierdurch ist eine individuelle Regelung von Substrattemperatur und Deckentemperatur möglich. Die Substrattemperatur liegt etwa bei 1600°C. Hierzu wird die vorzugsweise aus Grafit bestehende Trägerplatte auf eine Temperatur von 1700°C bis 1800°C aufgeheizt. Die Oberflächentemperatur der aus Grafit bestehenden Deckplatte liegt etwa bei 1600°C. Auch der Bereich der Deckplatte, der unmittelbar an das Gaseinlassorgan angrenzt, besitzt eine derart hohe Temperatur. Zufolge einer Kühlung besitzt das Gaseinlassorgan eine Temperatur von unter 100°C.

Ein Ausführungsbeispiel der Erfindung wird nachfolgend anhand beigefügter Zeichnungen erläutert. Es zeigen:

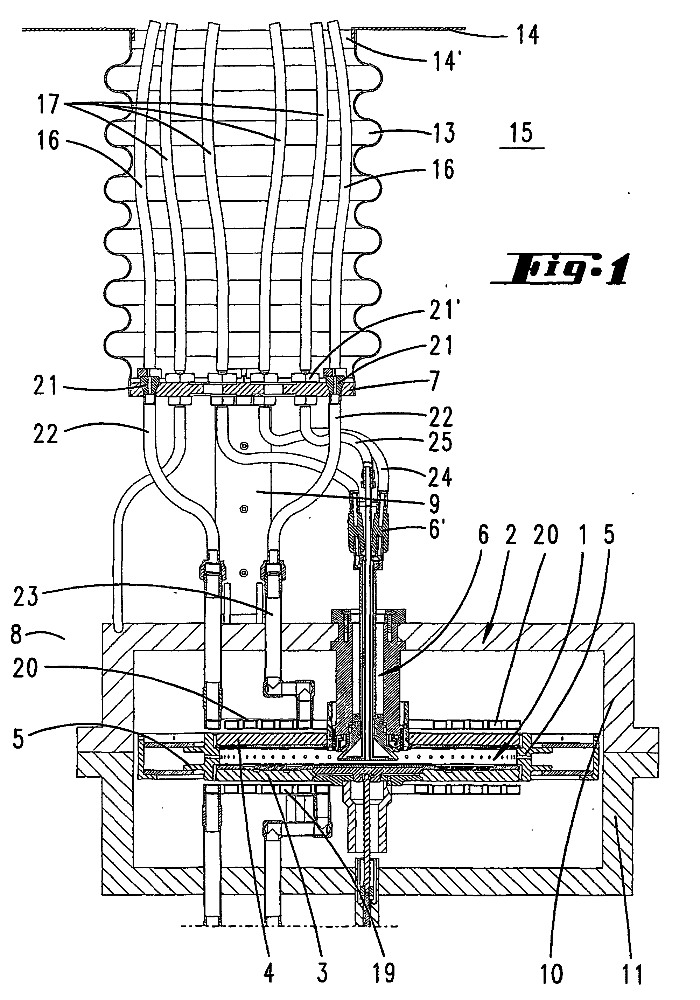

- Fig. 1: in schematischer Darstellung den Reaktor, bestehend aus der in dem Reaktorgehäuse angeordneten Prozesskammer mit den Versorgungsleitungen durch eine Öffnung einer Wandung einer Handschuhbox und

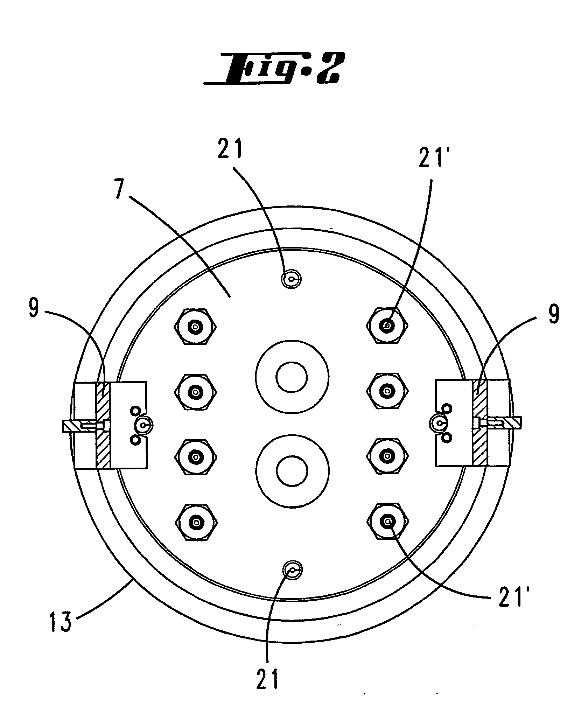

- Fig. 2: das Anschlussorgan aus der Froschperspektive.

Die im Ausführungsbeispiel dargestellte Vorrichtung dient zum monokristallinen Abscheiden von SiC-Schichten auf monokristallinen Si-Substraten in einem Heißwandreaktor. Diese Substrate können einen Durchmesser von 4 Zoll besitzen. Die Vorrichtung befindet sich in einem in den Zeichnungen nicht dargestellten Gehäuse. Dieses Gehäuse besitzt eine Handschuhbox, die zum Be- und Entladen der Prozesskammer dient. Der Deckel 8 des Reaktorgehäuses 2 ist in der Handschuhbox 15 öffenbar. Dabei hebt sich der Deckel 8 zusammen mit einem am Deckel befestigten Gaseinlassorgan 6, einer ebenfalls daran befestigten Hochfrequenzspule 20 und einer am Gaseinlassorgan 6 befestigten Deckplatte 4 ab. Des Weiteren hebt sich auch noch ein oberer Gehäusewandabschnitt 10, welcher mit Dichtungen auf einem unteren Gehäusewandabschnitt 11 aufliegt, mit ab, so dass die von der Trägerplatte 3 getragenen Substrathalter mit Substraten belegt werden können.

Die Zuleitungen 16 der HF-Spule 19 sind schlauchförmig ausgebildet. Sie liegen ebenso wie weitere Gas- oder Kühlwasserzuleitungen 17 in einem Wellschlauch 13. Dieser Wellschlauch 13 ist mit seinem einen Ende mit einer Öffnung 14' der Handschuhboxwand 14 dicht verbunden. Hierzu besitzt die Öffnung 14' beispielsweise einen Kragen. Das andere Ende des Wellschlauches 13 ist. dicht mit einem Anflanschorgan 7 verbunden. Dieses Anflanschorgan 7 besteht aus einer kreisrunden Kunststoff- bzw Pertinax-Platte. In dieser Platte liegen Zuleitungsdurchführungen 21, 21', an welche Schläuche oder Rohre 17 bzw. die HF-Zuleitungen 16 angeschraubt oder aufgesteckt sind. Die Platte 7 ist vom Deckel 8 beabstandet. Sie ist mit dem Deckel 8 jedoch über einen Träger 9 starr verbunden.

Wenn der Deckel 8 angehoben wird, so schieben sich die Wellen des Wellschlauches 13 zusammen. Die frei darin einliegenden Leitungen 16,17 können dann durch die Öffnung 14' geschoben werden.

In dem Reaktorgehäuse 2 befindet sich die Prozesskammer 1. Diese Prozesskammer 1 besitzt eine Trägerplatte 3, die Substrathalter trägt. Parallel zur Trägerplatte 3 erstreckt sich oberhalb derselben eine Deckplatte 4. Die Trägerplatte 3 wird von unten mittels einer wassergespülten HF-Spule 19 beheizt. Die Deckplatte 4 wird von oben mit einer ebenfalls wassergekühlten HF-Spule 20 beheizt. Die Trägerplatte 3 ist ringförmig gestaltet, wobei der Außendurchmesser etwa doppelt so groß ist wie ihr Innendurchmesser.

Von dem Anflanschorgan 7, welches parallel beabstandet liegt zum Gehäusedeckel 8 verlaufen unbewegliche, insbesondere starre Verbindungsleitungen 22 zu den Durchführungen 23, die die Leitverbindungen durch den Gehäusedeckel 8 darstellen. Weitere Leitungen verlaufen zum Kopf 6' des Gaseinleitungsorganes 6. Dies sind die Zuleitungen für die Reaktionsgase und die Zu- und Ableitung für das Kühlwasser des gekühlten Gaseinlassorganes 6.

Im Ausführungsbeispiel liegt die kreisrunde Scheibe, die das Anflanschorgan 7 ausbildet in unmittelbarer Gegenüberlage zur Öffnung 14' der Handschuhbox. Der Durchmesser der Öffnung 14' entspricht im Wesentlichen dem Durchmesser des Anflanschorganes 7. In der Platte 7 befinden sich Rohrverschraubungen 21' und Durchführungen 21 für die als Schlauch ausgebildeten HF-Zuleitungen 16.

Es stellt sich folgende Funktionsweise ein: Wird der Deckel 8 von nicht dargestellten Pneumatikzylindern angehoben, so bewegt sich das Anschlussorgan 7 in Richtung auf die Öffnung 14' zu. Die sich in dem Wellschlauch 13 befindlichen Leitungen 16, 17 werden Bereichsweise durch die Öffnung 14' hindurchgeschoben. Eventuell vorhandene Längenausgleichsabschnitte der Zuleitungen können außerhalb der Handschuhbox 15 angeordnet sein, so dass das Volumen der mit reinem Gas gefüllten Handschuhbox 15 minimal sein kann.

Alle offenbarten Merkmale sind (für sich) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen.

## Patentansprüche

1. Vorrichtung zum Abscheiden, insbesondere kristalliner Schichten auf einem oder mehreren, insbesondere ebenfalls kristallinen Substraten, mit einer in einem Reaktorgehäuse (2) angeordneten Prozesskammer (1), welche von oben durch eine mittels eines Deckels (8) verschließbare Reaktoröffnung mit den Substraten beladbar ist, wobei die Reaktorgehäuseöffnung in eine, insbesondere reinstgasgespülte Handschuhbox mündet und zum Deckel (8) Strom-, Flüssigkeits- oder Gasverbindungsleitungen (16, 17) führen,**dadurch gekennzeichnet, dass** die Strom-, Flüssigkeits- oder Gasverbindungsleitungen (16, 17) von außerhalb der Handschuhbox (15) zum Deckel (8) frei durch einen flexiblen, einendseitig dicht mit einem starr am Deckel (8) sitzenden Anflanschorgan (7) und anderendseitig dicht mit einer Öffnung (14') der Handschuhboxwandung (14) verbundenen Schlauch (13) geführt sind.

2. Vorrichtung nach oder insbesondere nach Anspruch 1, **dadurch gekennzeichnet, dass** das Anflanschorgan (7) mittels eines Trägers (9) starr am und beabstandet vom Deckel (8) befestigt ist.

3. Vorrichtung nach einem oder mehreren der vorhergehenden Ansprüche oder insbesondere danach, **dadurch gekennzeichnet, dass** das Anflanschorgan (7) eine Kunststoffplatte ist, mit gasdichten Durchführungen bzw. Verschraubungen für die Versorgungsleitungen (16, 17).

4. Vorrichtung nach einem oder mehreren der vorhergehenden Ansprüche oder insbesondere danach, **gekennzeichnet durch** eine über ein Gaseinlassorgan (6) fest mit dem Deckel (8) verbundene Deckplatte (4) der Prozesskammer (1).

5. Vorrichtung nach einem oder mehreren der vorhergehenden Ansprüche oder insbesondere danach, **gekennzeichnet durch** eine fest mit dem Deckel (8) verbundene, insbesondere wassergekühlte Hochfrequenz-Spule (29) zum Beheizen der Deckplatte (4).

6. Vorrichtung nach einem oder mehreren der vorhergehenden Ansprüche oder insbesondere danach, **dadurch gekennzeichnet, dass** Deckplatte (4) und Trägerplatte (3) getrennt beheizbar sind.

7. Vorrichtung nach einem oder mehreren der vorhergehenden Ansprüche oder insbesondere danach, **gekennzeichnet durch** eine drehangetriebene Trägerplatte (3), auf welcher auf jeweils einem Gaslager sich drehende Substrathalter sitzen.

8. Vorrichtung nach einem oder mehreren der vorhergehenden Ansprüche oder insbesondere danach, **dadurch gekennzeichnet, dass** das Anflanschorgan (7) sich parallel zur Öffnung (14') und unmittelbar unter ihr erstreckt.

9. Vorrichtung nach einem oder mehreren der vorhergehenden Ansprüche oder insbesondere danach, **dadurch gekennzeichnet, dass** das Anflanschorgan (7) und die Öffnung (14') eine etwa gleichgroße Querschnittsfläche besitzen.

## Claims

1. Device for depositing in particular crystalline layers on one or more, in particular likewise crystalline substrates, having a process chamber (1) which is disposed in a reactor housing (2) and can be loaded with the substrates from above through a reactor opening which can be closed off by means of a cover (8), the reactor-housing opening opening out into a glove box, which in particular is purged with ultrapure gas, and current, liquid or gas connection lines (16, 17) leading to the cover (8), **characterized in that** the current, liquid or gas connection lines (16, 17) are led from outside the glove box (15) to the cover (8) freely through a flexible tube (13) which on one end side is connected in a sealed manner to a flanged-on member (7) seated rigidly on the cover (8) and at the other end side is connected in a sealed manner to an opening (14') in the glove box wall (14).

2. Device according to or in particular according to Claim 1, **characterized in that** the flanged-on member (7) is secured rigidly to and at a spacing from the cover (8) by means of a support (9).

3. Device according to one or more of the preceding claims or in particular according thereto, **characterized in that** the flanged-on member (7) is a plastics plate with gastight lead-throughs or screw connections for the supply lines (16, 17).

4. Device according to one or more of the preceding claims or in particular according thereto, **characterized by** a cover plate (4), which is fixedly connected to the cover (8) via a gas-admission element (6), of the process chamber (1).

5. Device according to one or more of the preceding claims or in particular according thereto, **characterized by** a high-frequency coil (19), which is fixedly connected to the cover (8) and in particular is water-cooled, for heating the cover plate (4).

6. Device according to one or more of the preceding claims or in particular according thereto, **characterized in that** cover plate (4) and carrier plate (3) can be heated separately.

7. Device according to one or more of the preceding claims or in particular according thereto, **characterized by** a carrier plate (3) which is driven in rotation and on which substrate holders, which rotate on in each case one gas bearing, are seated.

8. Device according to one or more of the preceding claims or in particular according thereto, **characterized in that** the flanged-on member (7) extends parallel to and directly beneath the opening (14').

9. Device according to one or more of the preceding claims or in particular according thereto, **characterized in that** the flanged-on member (7) and the opening (14') have an approximately identically sized cross-sectional area.

## Revendications

1. Dispositif de déposition, en particulier de couches cristallines sur un ou plusieurs substrats, en particulier également cristallins, comportant une chambre de processus (1) qui est placée dans un boîtier de réacteur (2) et qui peut être chargée avec les substrats par le haut via une ouverture de réacteur pouvant être fermée par un couvercle (8), l'ouverture de boîtier de réacteur débouchant dans une boîte à gant pouvant en particulier être balayée avec un gaz très pur et des conduites de liaison (16, 17) de courant, de liquides ou de gaz étant amenées au couvercle (8), **caractérisé en ce que** les conduites de liaison (16, 17) de courant, de liquides ou de gaz sont amenés librement de l'extérieur de la boîte à gant (15) au couvercle (8) à travers un tuyau flexible (13) relié de façon étanche d'une part à un organe de fixation par bride (7) fixé au couvercle de manière rigide et d'autre part à une ouverture (14') ménagée dans la paroi (14) de la boîte à gant.

2. Dispositif selon la revendication 1, **caractérisé en ce que** l'organe de fixation par bride (7) est fixé rigidement au couvercle (8), à distance de celui-ci, au moyen d'un support (9).

3. Dispositif selon l'une ou plusieurs des revendications précédentes ou selon celles-ci en particulier, **caractérisé en ce que** l'organe de fixation par bride (7) est une plaque en matière plastique comportant des passages resp. des raccords à vis, étanches au gaz, destinés aux conduites ou conducteurs d'alimentation (16, 17).

4. Dispositif selon l'une ou plusieurs des revendications précédentes ou selon celles-ci en particulier, **caractérisé par** une plaque de couverture (4) de la chambre de processus (1), laquelle plaque de couverture est fixée au couvercle (8) par un organe d'introduction de gaz (6).

5. Dispositif selon l'une ou plusieurs des revendications précédentes ou selon celles-ci en particulier, **caractérisé par** une bobine à haute fréquence (19), en particulier à refroidissement hydraulique, qui est fixée au couvercle (8) et qui est destinée à chauffer la plaque de couverture (4).

6. Dispositif selon l'une ou plusieurs des revendications précédentes ou selon celles-ci en particulier, **caractérisé en ce que** la plaque de couverture (4) et la plaque de support (3) peuvent être chauffé séparément.

7. Dispositif selon l'une ou plusieurs des revendications précédentes ou selon celles-ci en particulier, **caractérisé par** une plaque de support (3), entraînée en rotation, sur laquelle sont placés des supports de substrat qui sont chacun rotatifs sur un palier de gaz.

8. Dispositif selon l'une ou plusieurs des revendications précédentes ou selon celles-ci en particulier, **caractérisé en ce que** l'organe de fixation par bride (7) s'étend parallèlement à l'ouverture (14') et directement sous celle-ci.

9. Dispositif selon l'une ou plusieurs des revendications précédentes ou selon celles-ci en particulier, **caractérisé en ce que** l'aire de la section de l'organe de fixation par bride (7) et celle de l'ouverture (14') sont à peu près égale.
